# EUROPEAN PATENT APPLICATION

(11) **EP 2 998 759 A1**
(43) Date of publication of application: **23.03.2016**
(21) Application number: 15184325.7
(22) Date of filing: 08.09.2015
(51) Int. Cl.: G01R 33/30, G01R 33/31

(54) **AN NMR EXTRACTABLE PROBE CASSETTE**

(30) Priority: 15.09.2014 US 201462050221 P
(71) Applicant: Aspect AI Ltd, 7319900 Shoham (IL)
(72) Inventor: RAPOPORT, Uri, 73115 Moshav Ben Shemen (IL); Rabinovitz, Itzchak, 74030 Ness Ziona (IL); COHEN, Tal, Herzliya (IL)
(74) Representative: Lecomte & Partners

(57) **Abstract**

The present invention proposes an extractable nuclear magnetic resonance (NMR) probe cassette (100) for reversibly positioning a probe in an NMR device, as well as a corresponding method for using such an NMR probe cassette

## Description

### FIELD OF THE INVENTION

The present invention generally relates to nuclear magnetic resonance (NMR) testing apparatus and in particular to extractable probe cassettes for NMR device, means and methods thereof.

### BACKGROUND OF THE INVENTION

Nuclear magnetic resonance (NMR) testing of substances to determine the constituents therein is well known in the art. In known devices, the sample can be arranged between the poles of a magnet and enclosed by a wire coil to enable a sample to be subjected to RF electromagnetic pulses of a predetermined frequency. The resulting NMR pulse generated by the nuclei of the sample under test can be detected and processed by the NMR device in a well-known manner to identify the sample constituents.

NMR analysis can be performed in devices commonly known as spectrometers. These spectrometers are designed so as to have a probe, accepting the sample to be analyzed, between poles of a magnet. The RF coils and tuning circuitry associated with the probe create a field (B) that rotates the net magnetization of the nucleus. These RF coils also detect the transverse magnetization as it passes across the X, Y plane. The RF coil pulses the sample nucleus at the Lamor frequency, so as to generate a readable signal for sample identification.

An exemplary probe that performs in accordance with that described immediately above is disclosed in commonly owned U.S. Pat. No. 5,371,464 (Rapoport), and is incorporated herein as a reference. This probe and others like it, while an improvement in the art, still have several disadvantages.

A problem with current configurations of probe systems is their built-in assembly. NMR probes are provided as an inherent feature of the NMR device and are manufactured intrinsically in the device. As such, any defect, breakage or contamination of the probes involves the disassembly of the entire NMR device and requires expensive and elaborate repair. In addition, the probe comprises a conduit for inserting a sample. A smaller or larger diameter of the sampling conduit may be desired and such customization is rather limited in the probes available today. A customized opening will enable a more accurate positioning of the RF coils, and a larger signal-to-noise analysis. Another disadvantage of currently available built-in probes is the difficulty of cleaning such a probe that is part of the NMR apparatus.

Thus, there is a long-felt need for a probe that is comprised in a cassette which is easily extractable and exchangeable, for easy repair or for various samplings, having different conduit diameters or configurations and customized magnetic field.

### SUMMARY OF THE INVENTION

It is thus one object of the present invention to provide an extractable nuclear magnetic resonance (NMR) probe cassette for reversibly positioning a probe in an NMR device, comprising a body having a central opening along its longitudinal axis, the body of a non-magnetic material; a conduit extending through the central opening in the body, the conduit for containing a sample and the conduit is of a non-magnetic material; and an RF coil that spirals at least a portion of the central opening; wherein the probe cassette further comprises at least one longitudinal guide along the body's longitudinal axis for reversibly and reproducibly guide the probe cassette in and out of an NMR device.

It is another object of the present invention to provide the NMR probe cassette as mentioned above, further comprising at least one pin for guiding position of the probe cassette in an NMR device.

It is another object of the present invention to provide the NMR probe cassette as mentioned above, wherein the body is of a material selected from the group consisting of alumina, stainless steel, molybdenum, titanium and any combination thereof.

It is another object of the present invention to provide the NMR probe cassette as mentioned above, wherein the longitudinal guides are selected from the group consisting of tracks, rails, grooves and any combination thereof.

It is another object of the present invention to provide the NMR probe cassette as mentioned above, wherein the body comprises two parallel longitudinal guides.

It is another object of the present invention to provide the NMR probe cassette as mentioned above, wherein the parallel longitudinal guides are secured to either side of the body.

It is another object of the present invention to provide the NMR probe cassette as mentioned above, wherein the conduit is cylindrical.

It is another object of the present invention to provide the NMR probe cassette as mentioned above, wherein the conduit is adapted to support a sample tube characterized by a diameter of between about 5 mm to about 10 mm.

It is another object of the present invention to provide the NMR probe cassette as mentioned above, wherein the conduit is of a material selected from the group consisting of alumina, glass, stainless steel, titanium, molybdenum, sapphire, silicon and any combination thereof.

It is another object of the present invention to provide the NMR probe cassette as mentioned above, wherein the probe cassette further comprises a heat circulation system.

It is another object of the present invention to provide the NMR probe cassette as mentioned above, further comprising a frequency lock unit positioned within the body and in operative communication with the RF coil.

It is another object of the present invention to provide the NMR probe cassette as mentioned above, wherein the probe cassette further comprises at least one locking means.

It is another object of the present invention to provide the NMR probe cassette as mentioned above, wherein the top opening of the conduit further comprises a tube holder.

It is another object of the present invention to provide the NMR probe cassette as mentioned above, wherein the tube holder is of a material selected from the group comprising of silicon, glass, alumina and any combination thereof.

It is another object of the present invention to provide the NMR probe cassette as mentioned above, wherein the conduit is characterized by an open base portion for allowing flow of a sample.

It is another object of the present invention to provide the NMR probe cassette as mentioned above, wherein the base portion is configured to allow the incorporation of an end portion; the end portion's top defines a floor for insertion of a sample tube.

It is another object of the present invention to provide the NMR probe cassette as mentioned above, wherein the base portion is characterized by guides for allowing respective mating with the end portion.

It is another object of the present invention to provide the NMR probe cassette as mentioned above, wherein the guides define a scale of heights of the end portion.

It is another object of the present invention to provide the NMR probe cassette as mentioned above, further comprising control electronics in operative communication with the RF coil and the frequency lock unit.

It is another object of the present invention to provide the NMR probe cassette as mentioned above, wherein the body further includes at least one tube holder located along the body's longitudinal axis and having an opening configured to accommodate and support a sample tube.

It is another object of the present invention to provide the NMR probe cassette as mentioned above, wherein the tube holder is of a material selected from the group comprising of silicon, glass, alumina and any combination thereof.

It is further an object of the present invention to provide a method for reversibly positioning an extractable nuclear magnetic resonance (NMR) probe cassette in an NMR device, comprising the steps of obtaining an NMR probe cassette comprising of: a body having a central opening along its longitudinal axis, the body of a non-magnetic material; a conduit extending through the central opening in the body, the conduit for containing a sample and the conduit is of a non-magnetic material; and an RF coil that spirals at least a portion of the central opening; positioning the NMR probe cassette inside an NMR device; wherein the step of obtaining an NMR probe cassette further comprises obtaining the probe cassette comprising at least one longitudinal guide along the body's longitudinal axis; further wherein the step of positioning is done by reversibly and reproducibly guiding the probe cassette in and out of an NMR device by use of the at least one longitudinal guide.

It is another object of the present invention to provide the method as mentioned above, further comprising the steps of obtaining an NMR probe further comprising at least one pin and guiding position of the probe cassette in an NMR device through the at least one pin

It is another object of the present invention to provide the method as mentioned above, further comprising the step of selecting the body to be from a material selected from the group consisting of alumina, stainless steel, molybdenum, titanium and any combination thereof.

It is another object of the present invention to provide the method as mentioned above, further comprising the step of selecting the longitudinal guides from the group consisting of tracks, rails, grooves and any combination thereof.

It is another object of the present invention to provide the method as mentioned above, further comprising the step of obtaining the probe cassette wherein the body comprises two parallel longitudinal guides.

It is another object of the present invention to provide the method as mentioned above, further comprising the step of obtaining the probe cassette wherein the body's two parallel longitudinal guides are secured to either side of the body.

It is another object of the present invention to provide the method as mentioned above, further comprising the step of obtaining the probe cassette wherein the conduit is cylindrical.

It is another object of the present invention to provide the method as mentioned above, further comprising the step of adapting the probe cassette's conduit to support a sample tube characterized by a diameter of between about 5 mm to about 10 mm.

It is another object of the present invention to provide the method as mentioned above, further comprising the step of selecting the conduit's material from the group consisting of alumina, glass, stainless steel, titanium, molybdenum, sapphire, silicon and any combination thereof.

It is another object of the present invention to provide the method as mentioned above, further comprising the step of obtaining a probe cassette further comprising a heat circulation system.

It is another object of the present invention to provide the method as mentioned above, further comprising the step of obtaining a probe cassette further comprising a frequency lock unit positioned within the body and in operative communication with the RF coil.

It is another object of the present invention to provide the method as mentioned above, further comprising the step of obtaining a probe cassette further comprising at least one locking means.

It is another object of the present invention to provide the method as mentioned above, further comprising the step of obtaining the conduit further comprising a tube holder at the top opening of the conduit.

It is another object of the present invention to provide the method as mentioned above, further comprising the step of selecting the tube holder's material from the group consisting of silicon, glass, alumina and any combination thereof.

It is another object of the present invention to provide the method as mentioned above, further comprising the step of obtaining the probe cassette's conduit, wherein the conduit is characterized by an open base portion for allowing flow of a sample.

It is another object of the present invention to provide the method as mentioned above, further comprising the steps of configuring the base portion to allow the incorporation of an end portion; and incorporating an end portion into the base portion, thereby defining a floor with the end portion's top for insertion of a sample tube.

It is another object of the present invention to provide the method as mentioned above, further comprising the step of configuring the base portion to be characterized by guides for allowing respective mating with the end portion.

It is another object of the present invention to provide the method as mentioned above, further comprising the step of defining a scale of heights of the end portion with the guides.

It is another object of the present invention to provide the method as mentioned above, further comprising the step of obtaining the probe cassette further comprising control electronics in operative communication with the RF coil and the frequency lock unit.

It is another object of the present invention to provide the method as mentioned above, further comprising the steps of incorporating in the probe cassette's body at least one tube holder located along the body's longitudinal axis and configuring the tube holder to have an opening, thereby accommodating and supporting a sample tube.

It is another object of the present invention to provide the method as mentioned above, further comprising the step of selecting the tube holder's material from the group consisting of silicon, glass, alumina and any combination thereof.

Unless specifically stated otherwise, features of the above objects may be combined with one another unless this would result in an obviously contradictory combination.

### BRIEF DESCRIPTION OF THE DRAWINGS

In order to understand the invention and to see how it may be implemented in practice, several embodiments will now be described, by way of non-limiting example only, with reference to the accompanying drawing, in which:
FIG. 1 schematically presents a front view of the probe cassette 100 as disclosed in an embodiment of the present invention.
FIG. 2 schematically presents a top view of the probe cassette of FIG. 1, illustrating the sample introduction section.
FIG. 3 schematically presents a bottom view of the probe cassette of FIG. 1, illustrating the sample outlet section.
FIG. 4 schematically presents a 3D perspective view of the probe cassette of FIG. 1.
FIG. 5 schematically presents a cross-sectional view of the 3D perspective view shown in FIG. 4, illustrating the center of the probe's sample conduit as depicted in lines (a).

### DETAILED DESCRIPTION OF THE PREFERRED EMBODIMENTS

Technical features described in the context of specific embodiments may be combined with features described for other embodiments, unless specifically specified otherwise.

The following description is provided, alongside all chapters of the present invention, so that to enable any person skilled in the art to make use of said invention and sets forth the best modes contemplated by the inventor of carrying out this invention. Various modifications, however, will remain apparent to those skilled in the art, since the generic principles of the present invention have been defined specifically to provide an extractable nuclear magnetic resonance (NMR) probe cassette for reversibly positioning a probe in an NMR device, comprising a body having a central opening along its longitudinal axis, the body of a non-magnetic material; a conduit extending through the central opening in the body, the conduit for containing a sample and the conduit is of a non-magnetic material; and an RF coil that spirals at least a portion of the central opening; wherein the probe cassette further comprises at least one longitudinal guide along the body's longitudinal axis for reversibly and reproducibly guide the probe cassette in and out of an NMR device.

The term "**about**" refers hereinafter to a range of 25% below or above the referred value.

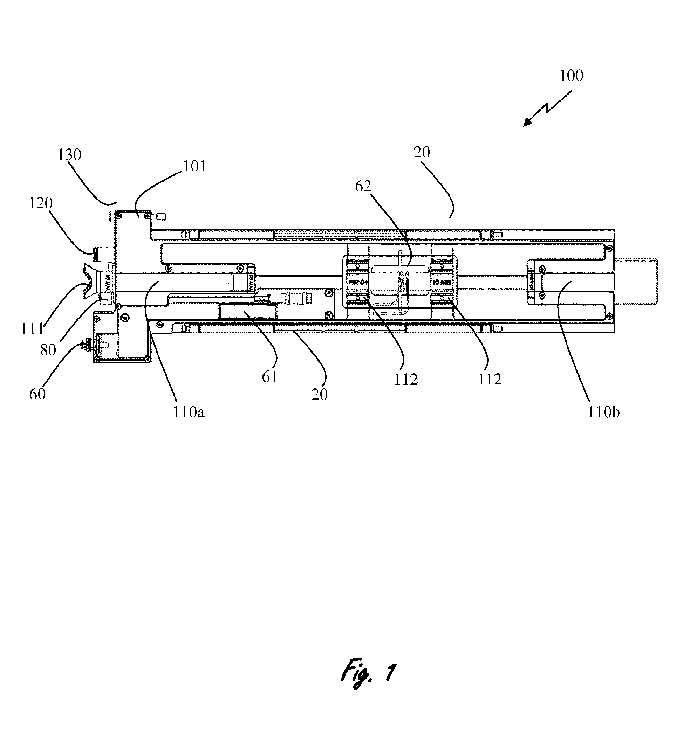

Reference is now made to FIG. 1 schematically presenting a front view of the probe cassette **100**. The probe cassette includes a body **101** which comprises a central opening along its longitudinal axis, for the insertion of a sample, in a tube or otherwise. The body is made of a non-magnetic material, and could be made of, in a non-limiting example, alumina, stainless steel, molybdenum, titanium and any combination thereof. Inside the central opening resides a conduit, which in some embodiments may have two distinct sections, a top section **110a** and a bottom section **110b**. A novel aspect of the present invention is the incorporation of at least one longitudinal guide **20**, and preferably two such longitudinal guides **20**, along the longitudinal axis of the probe cassette's body. These longitudinal guides are for reversibly, reproducibly and accurately inserting and taking out the probe cassette in and out of an NMR device. The guides could be any mechanical guiding mechanism such as grooves, rails, tracks, etc. The guides could be, for example, in accordance with that detailed in US. Pat. No. 7,883,289, incorporated herein as a reference by its entirety. At least part of the central opening is encompassed by an RF coil **62**, which spirals around the sample containing area.

An embodiment of the present invention may contain control electronics **61** and these control electronics may be further regulated by RF modulating means **60**. The control electronics may also be in operative communication with a frequency lock RF coil **80**.

The conduit **110**, running across the central opening of the probe cassette, or divided between a top section **110a** and a base portion **110b**, could be made of any non-magnetic material, and could be made in a non-limiting example of alumina, glass, stainless steel, titanium, molybdenum, sapphire, silicon and any combination thereof. The conduit and any of its segmental parts, could take the preferable shape of a cylinder, but could also assume any other shape (e.g. square, rectangle, polygonal, triangular, oval, etc.). The preferable diameter of the conduit is preferably configured to accommodate a sample tube characterized by a diameter of between about 5 mm and 10 mm, and could also be about 8 mm tube.

In an embodiment of the present invention, as further illustrated in FIG. 1, the conduit at its top end may contain a tube holder **111** in its opening. The tube holder **111** is preferably in the form of a cylinder or the like (although other shapes, e.g. square, rectangle, polygonal, triangular, oval, etc., are also permissible), and could be made from any non-magnetic material, such as in a non-limiting example, silicon, glass, alumina and any combination thereof. At least one other tube holder **112** along the central opening of the probe cassette presents another embodiment of the present invention. The tube holder may have any shape which could clasp any tube having any shape. A preferable embodiment is the incorporation of two such tube holders. The tube holders' function is to accurately locate and guide the sample tube inside the probe cassette.

The conduit's base portion **110b** may be in an embodiment configured to allow the incorporation of an end portion. The base portion section may comprise any guides, grooves, rails or the like to allow the sliding of such an end portion. The end portion is mountable to present a mechanical stopper and barrier for the incorporation of a sample tube. That is, the end portion makes up the floor by which the sample tube, inserted through the conduit, will be blocked and held in place. These guides may have a plurality of height adjusters which enable the adjustment of the height of the floor the end portion is creating. Thus, the guides may define a scale of heights which can be determined according to the sample tube used.

The probe cassette in some embodiments may also comprise a heat circulation system **120**. The heat circulation system may be, for example, an aperture through which hot or cold air will be able to leave the probe cassette's body and be replaced with air outside the body, which is cooler/warmer. The air may leave in a passive way, or by any ventilation means, including sensor feedback in operable communication with ventilation motors.

The probe cassette may also comprise at least one locking means **130**, intended to secure the probe cassette in place inside the NMR device.

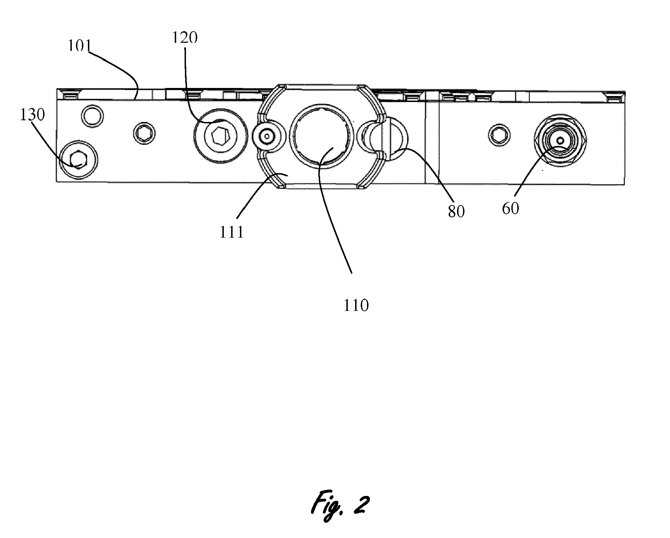

Reference is now made to **FIG. 2**, illustrating a top view of an embodiment of the probe cassette as disclosed in the present application, and as illustrated in **FIG. 1**. In the top view is shown the body **101**, having the central opening containing the conduit **110**, which is intended for inserting a flow-through sample, or a sample tube. Atop the conduit opening, in some embodiments a tube holder **111** may be available for easier insertion of a sample tube. In addition, the top of the probe cassette may also comprise RF modulating means **60** and a frequency lock RF coil **80**, as well as at least one aperture of a heat circulation system **120** and at least one locking means **130**.

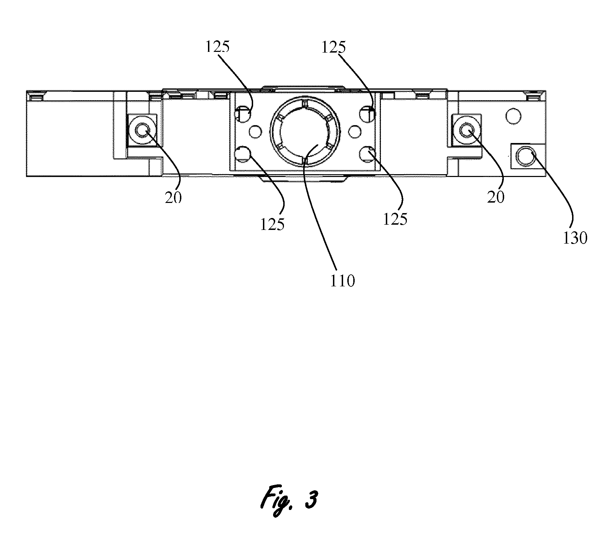

Reference is now made to **FIG. 3**, illustrating a bottom view of an embodiment of the probe cassette as disclosed in the present invention, and as illustrated in **FIG. 1**. The bottom view illustrates the probe cassette body **101**, having the central opening with conduit **110**. An embodiment of the heat circulation system is shown by ventilation holes **125**, which assist in circulating hot or cold air in and out of the probe cassette, following the temperature of the sample. The holes **125**, may be in addition to other ventilation apertures, such as the ventilation aperture **120** found at the top of the probe cassette. The bottom view also illustrates an embodiment of two rails **20**, found in each side of the probe cassette's body, and which are preferably according to the rails depicted in US. Pat. No. 7,883,289. The at least one locking means **130** can be seen looking through the bottom view, but is actually found on the top of the probe cassette.

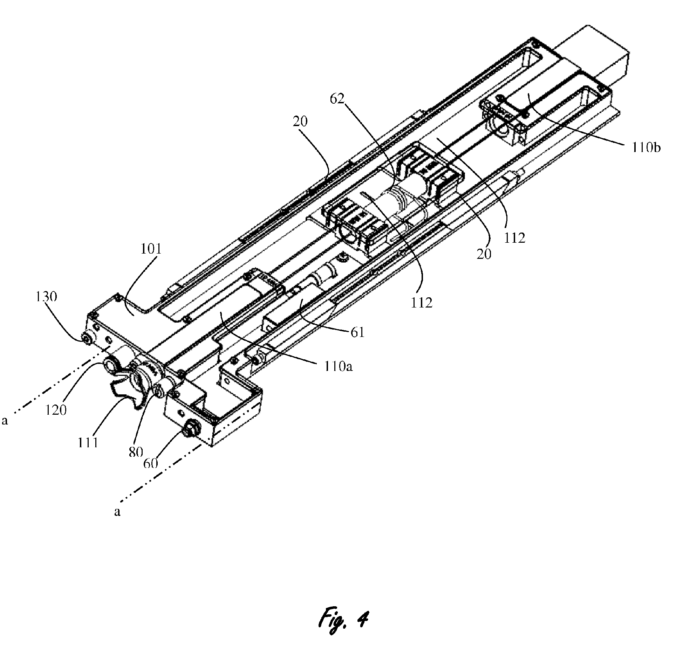

Reference is now made to **FIG. 4**, illustrating a 3D perspective view of the probe cassette as illustrated in **FIG. 1**. The illustration shows the main body **101**, having a central opening and containing the conduit **110**, which under some embodiments may be composed of a top section **110a** and a base portion **110b**. The sample containing area is at least partially surrounded by RF coils **62**, which may be in operative communication with control electronics **61**, and may be further regulated by RF modulating means **60**. The control electronics may also be in operative communication with a frequency lock RF coil **80**. The probe cassette contains at least one longitudinal guides **20**, which make the cassette an extractable one. A preferable embodiment of the probe cassette comprises two such longitudinal guides **20**, which are preferably incorporated at the sides of the probe cassette's body, and are intended for guiding, inserting and positioning the probe cassette reversibly and accurately into and out of an NMR device. The top of the probe cassette may comprise a tube holder **111**, at the opening of the conduit, for supporting a sample tube, and at least one more tube holder **112**, preferably two, is located along the longitudinal axis of the probe cassette and is intended for supporting a sample tube. The sample tube may be further supported at its bottom end by an end portion, which may be incorporated at the end portion **110b** of the conduit. The top portion of the probe cassette may further comprise at least one heat circulation system **120** and at least one locking means **130**.

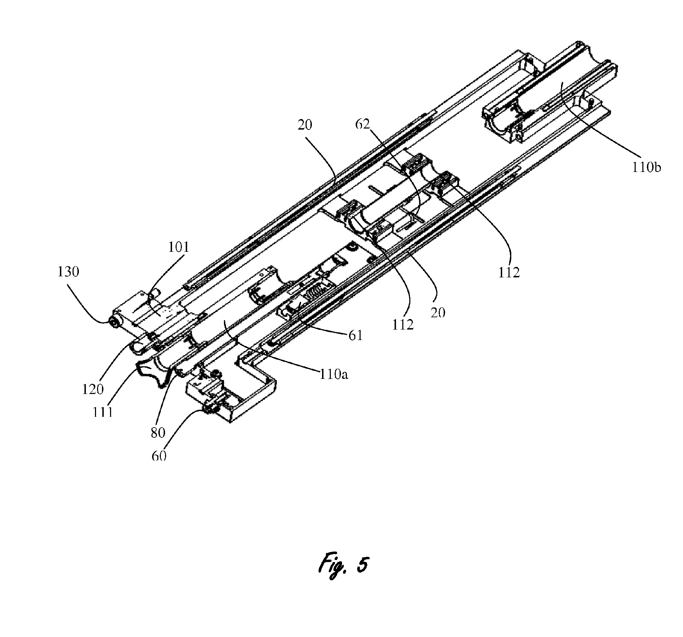

Reference is now made to **FIG. 5**, illustrating a cross-section taken along the center of the probe cassette, in lines (a), as illustrated in **FIG. 4**. The probe cassette is in accordance with the one shown in **FIG. 4** and similar reference numbers indicate similar features of the probe cassette.

While the invention is susceptible to various modifications and alternative forms, specific embodiments thereof have been shown by way of example in the drawings and the above detailed description. It should be understood, however, that it is not intended to limit the invention to the particular forms disclosed, but on the contrary, the intention is to cover all modifications, equivalents, and alternatives falling within the spirit and scope of the invention as defined by the appended claims.

## Claims

1. An extractable nuclear magnetic resonance (NMR) probe cassette (100) for reversibly positioning a probe in an NMR device, comprising:
a. a body (120) having a longitudinal axis having an opening at one end of said body, said opening centered on said axis, said body of a non-magnetic material;
b. a conduit (101) extending through said central opening in said body, said conduit for containing a sample and said conduit is of a non-magnetic material; and
c. an RF coil (62) that spirals at least a portion of said central opening; **characterized by** said probe cassette further comprising at least one longitudinal guide (20) along said body's longitudinal axis for reversibly and reproducibly guiding said probe cassette in and out of an NMR device.

2. The NMR probe cassette according to claim 1, further comprising at least one pin for guiding position of said probe cassette in an NMR device.

3. The NMR probe cassette according to claim 1, wherein said body is of a material selected from the group consisting of alumina, stainless steel, molybdenum, titanium and any combination thereof.

4. The NMR probe cassette according to claim 1, wherein at least one of the following is being held true:
a. said longitudinal guides are selected from the group consisting of tracks, rails, grooves and any combination thereof;
b. said body comprises two parallel longitudinal guides and said parallel longitudinal guides are secured to either side of said body;
c. said body further includes at least one tube holder located along said body's longitudinal axis and having an opening configured to accommodate and support a sample tube, and said tube holder is of a material selected from the group consisting of silicon, glass, alumina and any combination thereof.

5. The NMR probe cassette according to claim 1, wherein at least one of the following is being held true:
a. said conduit is cylindrical;
b. said conduit is adapted to support a sample tube **characterized by** a diameter of between about 5 mm to about 10 mm;
c. said conduit is of a material selected from the group consisting of alumina, glass, stainless steel, titanium, molybdenum, sapphire, silicon and any combination thereof;
d. the top portion of said conduit further comprises a tube holder and said tube holder is of a material selected from the group consisting of silicon, glass, alumina and any combination thereof.

6. The NMR probe cassette according to claim 1, wherein at least one of the following is being held true:
a. said probe cassette further comprises a heat circulation system;
b. said probe cassette further comprises a frequency lock unit positioned within said body and in operative communication with said RF coil;
c. said probe cassette further comprises at least one locking means.

7. The NMR probe cassette according to claim 1, wherein said conduit is **characterized by** an open base portion for allowing flow of a sample.

8. The NMR probe cassette according to claim 7, wherein said base portion is configured to allow the incorporation of an end portion; said end portion's top defines a floor for insertion of a sample tube, and said base portion is **characterized by** guides for allowing respective mating with said end portion, and optionally said guides define a scale of heights of said end portion

9. The NMR probe cassette according to claim 1, further comprising control electronics in operative communication with said RF coil and said frequency lock unit.

10. A method for reversibly positioning an extractable nuclear magnetic resonance (NMR) probe cassette (100) in an NMR device, comprising the steps of:
a. obtaining an NMR probe cassette comprising of:
i. a body (120) having a central opening along its longitudinal axis, said body of a non-magnetic material;
ii. a conduit (101) extending through said central opening in said body, said conduit for containing a sample and said conduit is of a non-magnetic material; and
iii. an RF coil (62) that spirals at least a portion of said central opening;
b. positioning said NMR probe cassette inside an NMR device;
**characterized by** said step of obtaining an NMR probe cassette further comprising obtaining said probe cassette comprising at least one longitudinal guide (20) along said body's longitudinal axis;
further wherein said step of positioning is done by reversibly and reproducibly guiding said probe cassette in and out of an NMR device by use of said at least one longitudinal guide.

11. The method according to claim 10, further comprising at least one of the following steps:
a. obtaining an NMR probe further comprising at least one pin and guiding position of said probe cassette in an NMR device through said at least one pin;
b. selecting said longitudinal guides from the group consisting of tracks, rails, grooves and any combination thereof;
c. obtaining said probe cassette wherein said body comprises two parallel longitudinal guides secured to either side of said body;
d. obtaining said probe cassette wherein said conduit is cylindrical and adapting said probe cassette's conduit to support a sample tube **characterized by** a diameter of between about 5 mm to about 10 mm.

12. The method according to claim 10, further comprising at least one of the following steps:
a. obtaining a probe cassette further comprising a heat circulation system;
b. obtaining a probe cassette further comprising a frequency lock unit positioned within said body and in operative communication with said RF coil;
c. obtaining a probe cassette further comprising at least one locking means.

13. The method according to claim 10, further comprising the step of obtaining said probe cassette's conduit, wherein said conduit is **characterized by** an open base portion for allowing flow of a sample and further configuring said base portion to allow the incorporation of an end portion; and incorporating an end portion into said base portion, thereby defining a floor for blocking further insertion of a sample tube.

14. The method according to claim 10, further comprising the step of configuring said base portion to be have guides for allowing respective mating with said end portion and optionally configuring said guides to define a scale of heights of said end portion's position.

15. The method according to claim 10, further comprising the step of obtaining said probe cassette further comprising control electronics in operative communication with said RF coil and said frequency lock unit.
